# EUROPEAN PATENT APPLICATION

(11) **EP 4 521 869 A1**
(43) Date of publication of application: **12.03.2025**
(21) Application number: 23823442.1
(22) Date of filing: 08.02.2023
(51) Int. Cl.: H05K 7/20, H02B 1/56, H02M 7/48

(54) **ELECTRIC SWITCHBOARD**

(30) Priority: 14.06.2022 JP 2022096075
(71) Applicant: Mitsubishi Heavy Industries, Ltd., Tokyo 100-8332 (JP)
(72) Inventor: SANADA Tomohiko, Tokyo 100-8332 (JP); IIDA Ryo, Tokyo 100-8332 (JP)
(74) Representative: Studio Torta S.p.A.
(86) International application number: PCT/JP2023/004093
(87) International publication number: WO 2023/243137

(57) **Abstract**

An electric switchboard according to the present disclosure includes: a power converter housed in a casing; an intake port and an exhaust port; a fan that causes air in the casing to flow from the intake port to the exhaust port; a first partition section dividing the inside of the casing into a first region where a low-heat-generation component is arranged and a second region where no low-heat-generation component is arranged; and a second partition section that is arranged downstream of the first partition section and divides the second region into an inner region where a high-heat-generation component is arranged and an outer area where no high-heat-generation component is arranged. The first partition section has a first inlet through which air in the casing flows into the first region, and a first outlet through which air that has flowed through the first region flows out to the second region. The second partition section has a second inlet that faces the first outlet while being spaced apart from the first outlet, and a second outlet through which air that has flowed through the inner region flows out to the outer region, the second partition section being formed so that the flow path cross-sectional area of the inner region gradually increases from the second inlet to the second outlet.

## Description

### Technical Field

The present disclosure relates to a switchboard.

Priority is claimed on Japanese Patent Application No. 2022-96075, filed June 14, 2022, the content of which is incorporated herein by reference.

### Background Art

For example, PTL 1 discloses a switchboard device including a first ventilation path in which a part of high-heat-generation components is arranged inside and a second ventilation path in which another part of high-heat-generation components is arranged inside while being independent from the first ventilation path. The high-heat-generation component is a power conversion component in the switchboard device. Heat generated from the high-heat-generation components inside the first ventilation path and the second ventilation path is removed by driving each of the first fan and the second fan.

### Citation List

### Patent Literature

[PTL 1] Japanese Unexamined Patent Application Publication No. 2015-65747

### Summary of Invention

### Technical Problem

In recent years, in the field of switchboard devices, there has been an increasing trend toward higher voltages, larger currents, higher frequencies, and faster switching in order to improve added values. Accordingly, there is a demand for a technique for efficiently cooling a high-heat-generation component such as a fuse used in a switchboard device. In the technique described in PTL 1, since a plurality of ventilation paths independent of each other are formed, the structure for cooling the high-heat-generation component is complicated. In addition, it is necessary to provide a fan for each ventilation path. As a result, the manufacturing cost of the switchboard device may increase.

The present disclosure has been made to solve the above problems, and an object of the present disclosure is to provide a switchboard capable of efficiently cooling a high-heat-generation component while preventing an increase in manufacturing cost. Solution to Problem

In order to solve the above problem, a switchboard according to the present disclosure including: a casing; a power converter that is housed in the casing and converts electric power supplied from outside; an intake port capable of introducing air from an outside of the casing into the casing; an exhaust port capable of exhausting the air in the casing to the outside of the casing; a fan capable of causing the air introduced into the casing to flow from the intake port toward the exhaust port; a first partition section that divides a space inside the casing into a first region in which a low-heat-generation component electrically connected to the power converter is arranged and a second region in which the low-heat-generation component is not arranged; and a second partition section that is arranged downstream of the first partition section in a flow direction of the air and divides the second region into an inner region in which a high-heat-generation component electrically connected to the power converter and the low-heat-generation component is arranged and an outer region in which the high-heat-generation component is not arranged, in which the first partition section includes: a first inlet opening that allows the air introduced into the casing through the intake port to flow into the first region; and a first outlet opening that allows the air that has flowed through the first region to flow out to the second region, the second partition section includes: a second inlet opening that faces the first outlet opening in the flow direction of the air while being spaced apart from the first outlet opening; and a second outlet opening that allows the air that has flowed through the inner region to flow out to the outer region, and the second partition section is formed so that a flow path cross-sectional area of the inner region increases from the second inlet opening toward the second outlet opening.

### Advantageous Effects of Invention

According to the present disclosure, it is possible to provide a switchboard capable of efficiently cooling a high-heat-generation component while preventing an increase in manufacturing cost.

### Brief Description of Drawings

Fig. 1 is a cross-sectional view of a switchboard illustrating a configuration of the switchboard according to an embodiment of the present disclosure.
Fig. 2 is an enlarged view of a main part in Fig. 1.

### Description of Embodiments

Hereinafter, an embodiment of a switchboard according to the present disclosure will be described with reference to the accompanying drawings.

### [Switchboard]

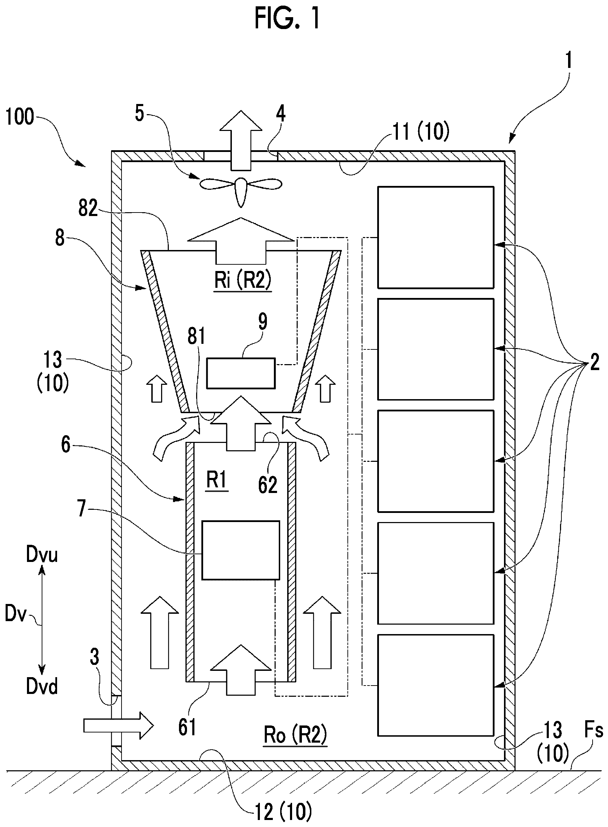

The switchboard in the present embodiment is a ship switchboard that converts electric power in a hull of a ship. A plurality of switchboards are arranged in an equipment room or the like in the hull. As illustrated in Fig. 1, a switchboard 100 includes a casing 1, a power converter 2, an intake port 3, an exhaust port 4, a fan 5, a first partition section 6, a low-heat-generation component 7, a second partition section 8, and a high-heat-generation component 9. In Fig. 1, only one switchboard 100 among the plurality of switchboards 100 is illustrated.

### (Casing)

The casing 1 forms an outer shell of the switchboard 100. The casing 1 is formed of, for example, metal. The casing 1 is arranged on a floor surface Fs in the equipment room. The casing 1 in the present embodiment has a rectangular parallelepiped shape extending in a vertical direction Dv perpendicular to the direction in which the floor surface Fs extends, and defines a space capable of housing a device therein.

Hereinafter, for convenience of description, a direction in which the casing 1 extends is referred to as a "vertical direction Dv". At this time, the upper side in the vertical direction Dv is simply referred to as an "upper side Dvu", and the lower side opposite thereto is simply referred to as a "lower side Dvd". The casing 1 has an inner surface 10 constituted by a plurality of surfaces.

Among the plurality of surfaces constituting the inner surface 10, a surface arranged on the uppermost side Dvu and oriented toward the lower side Dvd is referred to as a "top surface 11", and a surface arranged on the lowermost side Dvd and facing the top surface 11 is referred to as a "bottom surface 12". The top surface 11 and the bottom surface 12 are, for example, parallel to each other. Four surfaces connecting the top surface 11 and the bottom surface 12 are referred to as "side surfaces 13". In Fig. 1, only two side surfaces 13 of the four side surfaces 13, which face each other and are parallel to each other, are illustrated due to space limitations.

### (Power Converter)

The power converter 2 is a device that converts power input from a power source or the like (not illustrated) arranged in the hull outside the casing 1 and outputs the converted power to the outside of the casing 1. A plurality of power converters 2 are housed in the casing 1. Fig. 1 illustrates an example in which five power converters 2 are housed in the casing 1. These power converters 2 are cooled by a liquid refrigerant or the like supplied from the outside.

### (Intake Port)

The intake port 3 is a hole through which air outside the casing 1 can be introduced into the casing 1. Therefore, the intake port 3 allows a space outside the casing 1 and a space inside the casing 1 to communicate with each other. The intake port 3 is arranged in the casing 1. The term "in the casing 1" in the present specification means being formed on the casing 1 to extend over the inner surface 10 and the outer surface of the casing 1, not inside the casing 1.

A plurality of intake ports 3 are formed on the casing 1 to penetrate from the side surface 13 of the casing 1 toward the outer surface. That is, the plurality of intake ports 3 are arranged in the direction in which the side surface 13 of the casing 1 extends. In Fig. 1, only one intake port 3 of the plurality of intake ports 3 is illustrated due to space limitations. The intake port 3 in the present embodiment penetrates from a portion of the side surface 13 of the casing 1 on the lower side Dvd close to the bottom surface 12 toward the outer surface.

### (Exhaust Port)

The exhaust port 4 is a hole through which air in the casing 1 can be exhausted to the outside of the casing 1. Therefore, the exhaust port 4 allows a space outside the casing 1 and a space inside the casing 1 to communicate with each other. The exhaust port 4 is arranged in the casing 1. The exhaust port 4 in the present embodiment is formed on the casing 1 to penetrate from the top surface 11 of the casing 1 toward the outer surface.

### (Fan)

The fan 5 is a blower capable of causing air introduced into the casing 1 through the intake port 3 to flow from the intake port 3 toward the exhaust port 4. The fan 5 is housed in the casing 1. The fan 5 in the present embodiment is provided on the top surface 11 of the casing 1 and arranged in the vicinity of the exhaust port 4.

When the fan 5 is driven, air is introduced into the casing 1 from the outside through the intake port 3. The air introduced into the casing 1 flows toward the upper side Dvu and is exhausted to the outside of the casing 1 through the exhaust port 4.

### (First Partition Section)

The first partition section 6 is a member that divides the space inside the casing 1 into a first region R1 and a second region R2. The first partition section 6 is formed of, for example, metal. The first partition section 6 is housed in the casing 1. The first partition section 6 in the present embodiment has a cylindrical shape extending in the vertical direction Dv when housed in the casing 1. The first partition section 6 is arranged on the upper side Dvu with respect to the intake port 3.

The first region R1 created by arranging the first partition section 6 in the casing 1 corresponds to the space inside the first partition section 6. The second region R2 created by arranging the first partition section 6 in the casing 1 corresponds to the space on the outer side of the first partition section 6. The power converter 2 and the fan 5 are arranged in the second region R2. Here, the first partition section 6 has a first inlet opening 61 and a first outlet opening 62.

The first inlet opening 61 allows a part of the air introduced into the casing 1 through the intake port 3 to flow into the first region R1. The first inlet opening 61 is oriented toward the lower side Dvd and faces the bottom surface 12. The first inlet opening 61 has a circular shape. The first outlet opening 62 allows the air that has flowed through the first region R1 to flow out to the second region R2 on the upper side Dvu with respect to the first partition section 6. The first outlet opening 62 is oriented toward the upper side Dvu and faces the top surface 11. The first outlet opening 62 has a circular shape.

A first region R1 between the first inlet opening 61 and the first outlet opening 62 is formed to have a uniform flow path cross-sectional area. The term "uniform" mentioned herein refers to being formed substantially uniformly, and slight manufacturing errors and design tolerances are allowed. The inner peripheral surface of the first partition section 6 has a cylindrical surface shape. The air in the casing 1 that does not flow into the first region R1 flows toward the upper side Dvu along the outer peripheral surface of the first partition section 6 in the second region R2 around the first partition section 6.

### (Low-heat-generation Component)

The low-heat-generation component 7 is a component electrically connected to the power converter 2. The low-heat-generation component 7 is housed in the casing 1. The low-heat-generation component 7 generates heat when the power converter 2 is driven. Examples of the low-heat-generation component 7 in the present embodiment include a terminal block connected to a terminal such as a positive electrode or a negative electrode provided in the power converter 2 by a bus bar or the like.

The low-heat-generation component 7 is arranged in the first region R1 defined by the first partition section 6. In other words, the low-heat-generation component 7 is housed in the first partition section 6. Therefore, the low-heat-generation component 7 is arranged in the first region R1, and the low-heat-generation component 7 is not arranged in the second region R2. In Fig. 1, a state of electrical connection between the low-heat-generation component 7 and the power converter 2 is conceptually illustrated by a two-dot chain line.

### (Second Partition Section)

The second partition section 8 is a member that divides the second region R2 inside the casing 1 into an inner region Ri and an outer region Ro. The second partition section 8 is formed of, for example, metal. The second partition section 8 is housed in the casing 1. The second partition section 8 in the present embodiment has a cylindrical shape formed into a truncated cone shape extending in the vertical direction Dv when housed in the casing 1.

The second partition section 8 is arranged downstream of the first partition section 6 in the air flow direction in the casing 1. That is, the second partition section 8 in the present embodiment is arranged on the upper side Dvu with respect to the first partition section 6.

The inner region Ri created by arranging the second partition section 8 in the casing 1 corresponds to the space inside the second partition section 8. The outer region Ro created by arranging the second partition section 8 in the casing 1 corresponds to the space on the outer side of the second partition section 8. The power converter 2 and the fan 5 are arranged in the outer region Ro of the second region R2. Here, the second partition section 8 has a second inlet opening 81 and a second outlet opening 82.

The second inlet opening 81 allows the air flowing out from the first region R1 through the first outlet opening 62 and a part of the air flowing toward the upper side Dvu through the second region R2 around the first partition section 6 to flow into the inner region Ri. The second inlet opening 81 is oriented toward the lower side Dvd and faces the bottom surface 12 and the first outlet opening 62. The second inlet opening 81 has a circular shape. The second outlet opening 82 allows the air flowing that has flowed through the inner region Ri to flow out to the outer region Ro on the upper side Dvu with respect to the second partition section 8. The second outlet opening 82 is oriented toward the upper side Dvu and faces the top surface 11. The second outlet opening 82 has a circular shape.

The inner region Ri between the second inlet opening 81 and the second outlet opening 82 is formed so that the flow path cross-sectional area increases from the second inlet opening 81 toward the second outlet opening 82. In other words, the second partition section 8 is formed so that the flow path cross-sectional area of the inner region Ri gradually increases from the second inlet opening 81 to the second outlet opening 82. The inner peripheral surface of the second partition section 8 has a funnel shape. The air in the casing 1 that does not flow into the inner region Ri flows toward the upper side Dvu along the outer peripheral surface of the second partition section 8 in the outer region Ro around the second partition section 8.

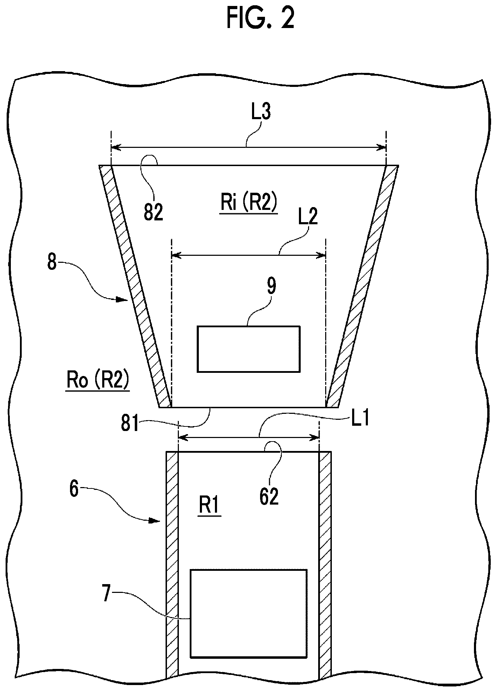

As illustrated in Fig. 2, the opening area of the second inlet opening 81 is larger than the opening area of the first outlet opening 62. Therefore, an inner diameter L2 of the second inlet opening 81 is larger than an inner diameter L1 of the first inlet opening 61. An inner diameter L3 of the second outlet opening 82 is larger than the inner diameter L2 of the second inlet opening 81.

### (High-heat-generation Component)

The high-heat-generation component 9 is a component electrically connected to the power converter 2 and the low-heat-generation component 7. The high-heat-generation component 9 is housed in the casing 1. The high-heat-generation component 9 generates more heat than the low-heat-generation component 7 when the power converter 2 is driven. Examples of the high-heat-generation component 9 in the present embodiment include circuit elements such as a fuse for the power converter 2 arranged in a current path connecting the power converter 2 and the low-heat-generation component 7, and a fuse (bus tie fuse) arranged in a current path extending from the low-heat-generation component 7 toward another switchboard 100.

The high-heat-generation component 9 is arranged in the inner region Ri defined by the second partition section 8. In other words, the high-heat-generation component 9 is housed in the second partition section 8. Specifically, the high-heat-generation component 9 is arranged in the vicinity of the second inlet opening 81 in the inner region Ri. Here, the "vicinity of the second inlet opening 81" means, for example, an inner region Ri on a lower half side when the second partition section 8 is divided into two in the vertical direction Dv.

Therefore, the high-heat-generation component 9 is arranged in the inner region Ri, and the high-heat-generation component 9 is not arranged in the outer region Ro. In Fig. 1, a state of electrical connection between the high-heat-generation component 9, and the power converter 2 and the low-heat-generation component 7 is conceptually illustrated by a two-dot chain line.

### (Operations and Effects)

In the above configuration, since the flow path cross-sectional area of the inner region Ri increases toward the upper side Dvu, when air flows through the inner region Ri as the fan 5 is driven, the air is decompressed and expanded in the inner region Ri. As a result, since the air pressure in the inner region Ri is lower than the air pressure in the outer region Ro, the flow velocity of the air in contact with the high-heat-generation component 9 arranged in the inner region Ri is higher than the flow velocity of the air flowing through the outer region Ro. In addition, the air flowing out of the first region R1 through the first outlet opening 62 and a part of the air flowing toward the upper side Dvu through the outer region Ro on the lower side Dvd with respect to the second partition section 8 are guided to the inner region Ri through the second inlet opening 81. That is, air having a temperature lower than the temperature of the air flowing through the first region R1 can be taken into the inner region Ri. By these operations, the high-heat-generation component 9 is efficiently cooled. Further, it is not necessary to additionally provide the fan 5 or the like in order to increase the flow velocity of the air in contact with the high-heat-generation component 9. Further, the above operations can be achieved by a simple configuration in which the first partition section 6 and the second partition section 8 are arranged in the casing 1. Therefore, it is possible to efficiently cool the high-heat-generation component 9 while preventing an increase in manufacturing cost of the switchboard 100.

According to the above configuration, the high-heat-generation component 9 is arranged on the upper side Dvu with respect to the low-heat-generation component 7. Accordingly, since the heat generated from the high-heat-generation component 9 and the air that has exchanged heat with the high-heat-generation component 9 move to the upper side Dvu with respect to the high-heat-generation component 9, the heat and the air do not reach the low-heat-generation component 7. Therefore, for example, the low-heat-generation component 7 is not affected by heat from the high-heat-generation component 9 as compared with a case where the low-heat-generation component 7 is arranged on the upper side Dvu with respect to the high-heat-generation component 9. As a result, the low-heat-generation component 7 can be efficiently cooled.

Further, in an equipment room or the like in the hull, the space in which the switchboard 100 can be installed may be limited. According to the above configuration, since the low-heat-generation component 7 and the high-heat-generation component 9 are air-cooled while being arranged in the vertical direction Dv, for example, it is possible to reduce an occupied space of the switchboard 100 in the direction parallel to the floor surface Fs as compared with a case where these components are arranged in the casing 1 in a direction parallel to the floor surface Fs.

Further, according to the above configuration, since the opening area of the second inlet opening 81 facing the first outlet opening 62 is larger than the opening area of the first outlet opening 62, the air flowing out from the first region R1 can be smoothly guided to the inner region Ri. Therefore, since the momentum of the air whose flow velocity has increased in the first region R1 can be efficiently used, the flow velocity of the air guided to the inner region Ri increases. As a result, the high-heat-generation component 9 can be cooled more efficiently.

According to the above configuration, since the second inlet opening 81 has a circular shape, the air flowing through the outer region Ro around the first partition section 6 can be smoothly guided to the inner region Ri. In addition, since the second outlet opening 82 has a circular shape, the air can smoothly flow out from the inner region Ri to the upper side Dvu as compared with a case where the second outlet opening 82 has another shape. As a result, the high-heat-generation component 9 can be cooled more efficiently.

### (Other Embodiments)

The embodiment of the present disclosure has been described in detail above with reference to the drawings. However, a specific configuration is not limited to the configuration of the embodiment, and additions, omissions, and substitutions of components and other modifications can be made without departing from the scope of the present disclosure.

In the above embodiment, the configuration in which the first partition section 6 has a cylindrical shape extending in the vertical direction Dv has been described, but the present invention is not limited to this configuration. Although detailed illustration is omitted, the first partition section 6 may have, for example, a plate shape, and may divide the space inside the casing 1 together with the side surface 13 on the inner surface 10 of the casing 1 into a first region R1 in which the low-heat-generation component 7 is arranged and a second region R2 in which the low-heat-generation component 7 is not arranged. Therefore, the first inlet opening 61 and the first outlet opening 62 are not limited to a circular shape, and may have a polygonal shape such as a rectangular shape.

In the above embodiment, the configuration in which the second partition section 8 has a cylindrical shape formed into a truncated cone shape extending in the vertical direction Dv has been described, but the present invention is not limited to this configuration. Although detailed illustration is omitted, the second partition section 8 may have, for example, a plate shape, and may divide the second region R2 together with the side surface 13 of the inner surface 10 of the casing 1 into an inner region Ri in which the high-heat-generation component 9 is arranged and an outer region Ro in which the high-heat-generation component 9 is not arranged. Therefore, the second inlet opening 81 and the second outlet opening 82 are not limited to a circular shape, and may have a polygonal shape such as a rectangular shape.

In the above embodiment, the configuration in which the first partition section 6 and the second partition section 8 are formed of metal has been described, but the present invention is not limited to this configuration. The first partition section 6 and the second partition section 8 may be formed of, for example, a synthetic resin or the like.

In the above embodiment, the configuration in which the intake port 3 is formed on the casing 1 to penetrate from the side surface 13 of the inner surface 10 of the casing 1 toward the outer surface has been described, but the present invention is not limited to this configuration. For example, the intake port 3 may be formed on the casing 1 to penetrate from the bottom surface 12 of the inner surface 10 of the casing 1 toward the floor surface Fs. In this case, a gap that allows the air to flow need only be formed between the casing 1 and the floor surface Fs while the casing 1 is supported by, for example, a stand or the like (not illustrated) arranged on the floor surface Fs.

In the above embodiment, the case where five power converters 2 are housed in the casing 1 has been described, but the number of power converters 2 is not limited to five. Four or less or six or more power converters 2 may be housed in the casing 1.

Further, in the above embodiment, the configuration in which the power converter 2 is cooled by the liquid refrigerant or the like supplied from the outside has been described, but the present invention is not limited to the liquid refrigerant. The power converter 2 may be configured to be cooled by air cooling or the like, for example. Specifically, the power converter 2 may be cooled by the air introduced into the casing 1 from the intake port 3.

In the above embodiment, the configuration in which the opening area of the second inlet opening 81 is larger than the opening area of the first outlet opening 62 has been described, but the present invention is not limited to this configuration. The opening area of the second inlet opening 81 may be the same as the opening area of the first outlet opening 62. Therefore, the inner diameter L2 of the second inlet opening 81 may be the same as the inner diameter L1 of the first inlet opening 61.

Therefore, the opening area of the second inlet opening 81 need only be equal to or larger than the opening area of the first outlet opening 62. This also makes it possible to achieve the above-described operations and effects. The inner diameter L3 of the second outlet opening 82 may be the same as the inner diameter L2 of the second inlet opening 81.

The switchboard 100 described in the above embodiment is not limited to a ship switchboard that converts electric power in a hull of a ship, but may be a switchboard used in a facility such as a power plant where electric power conversion is required.

### [Appendix]

The switchboard described in the embodiment is understood as follows, for example.

(1) A switchboard 100 comprising a first aspect including: a casing 1; a power converter 2 that is housed in the casing 1 and converts electric power supplied from outside; an intake port 3 capable of introducing air from an outside of the casing 1 into the casing 1; an exhaust port 4 capable of exhausting the air in the casing 1 to the outside of the casing 1; a fan 5 capable of causing the air introduced into the casing 1 to flow from the intake port 3 toward the exhaust port 4; a first partition section 6 that divides a space inside the casing 1 into a first region R1 in which a low-heat-generation component 7 electrically connected to the power converter 2 is arranged and a second region R2 in which the low-heat-generation component 7 is not arranged; and a second partition section 8 that is arranged downstream of the first partition section 6 in a flow direction of the air and divides the second region R2 into an inner region Ri in which a high-heat-generation component 9 electrically connected to the power converter 2 and the low-heat-generation component 7 is arranged and an outer region Ro in which the high-heat-generation component 9 is not arranged, in which the first partition section 6 includes: a first inlet opening 61 that allows the air introduced into the casing 1 through the intake port 3 to flow into the first region R1; and a first outlet opening 62 that allows the air that has flowed through the first region R1 to flow out to the second region R2, the second partition section 8 includes: a second inlet opening 81 that faces the first outlet opening 62 in the flow direction of the air while being spaced apart from the first outlet opening 62; and a second outlet opening 82 that allows the air that has flowed through the inner region Ri to flow out to the outer region Ro, and the second partition section 8 is formed so that a flow path cross-sectional area of the inner region Ri increases from the second inlet opening 81 toward the second outlet opening 82.

As a result, since the air pressure in the inner region Ri is lower than the air pressure in the outer region Ro, the flow velocity of the air in contact with the high-heat-generation component 9 arranged in the inner region Ri is higher than the flow velocity of the air flowing through the outer region Ro. Further, the air flowing out from the first region R1 and the air in the outer region Ro having a temperature lower than a temperature of the air flowing through the first region R1 are guided to the inner region Ri through the second inlet opening 81. Therefore, the high-heat-generation component 9 can be efficiently cooled. In addition, the above operations can be achieved by a simple configuration in which the first partition section 6 and the second partition section 8 are arranged in the casing 1 without additionally providing the fan 5 or the like.

(2) The switchboard 100 according to a second aspect is the switchboard 100 according to the first aspect, in which an opening area of the second inlet opening 81 may be equal to or larger than an opening area of the first outlet opening 62.

Accordingly, the air flowing out from the first region R1 can be smoothly guided to the inner region Ri. Therefore, the momentum of the air whose flow velocity has increased in the first region R1 can be efficiently used, and as a result, the flow velocity of the air guided to the inner region Ri can be increased.

(3) The switchboard 100 according to a third aspect is the switchboard 100 according to the first aspect or the second aspect, in which the second inlet opening 81 and the second outlet opening 82 may have a circular shape.

Accordingly, the air flowing through the outer region Ro around the first partition section 6 can be smoothly guided to the inner region Ri, and the air from the inner region Ri can flow out smoothly to the upper side Dvu.

### Industrial Applicability

According to the present disclosure, it is possible to provide a switchboard capable of efficiently cooling a high-heat-generation component while preventing an increase in manufacturing cost.

### Reference Signs List

1: casing
2: power converter
3: intake port
4: exhaust port
5: fan
6: first partition section
7: low-heat-generation component
8: second partition section
9: high-heat-generation component
10: inner surface
11: top surface
12: bottom surface
13: side surface
61: first inlet opening
62: first outlet opening
81: second inlet opening
82: second outlet opening
100: switchboard
Dv: vertical direction
Dvd: lower side
Dvu: upper side
Fs: floor surface
L1: inner diameter of first outlet opening
L2: inner diameter of second inlet opening
L3: inner diameter of second outlet opening
R1: first region
R2: second region
Ri: inner region
Ro: outer region

## Claims

1. A switchboard comprising:
a casing;
a power converter that is housed in the casing and converts electric power supplied from outside;
an intake port capable of introducing air from an outside of the casing into the casing;
an exhaust port capable of exhausting the air in the casing to the outside of the casing;
a fan capable of causing the air introduced into the casing to flow from the intake port toward the exhaust port;
a first partition section that divides a space inside the casing into a first region in which a low-heat-generation component electrically connected to the power converter is arranged and a second region in which the low-heat-generation component is not arranged; and
a second partition section that is arranged downstream of the first partition section in a flow direction of the air and divides the second region into an inner region in which a high-heat-generation component electrically connected to the power converter and the low-heat-generation component is arranged and an outer region in which the high-heat-generation component is not arranged,
wherein the first partition section includes:
a first inlet opening that allows the air introduced into the casing through the intake port to flow into the first region; and
a first outlet opening that allows the air that has flowed through the first region to flow out to the second region,
the second partition section includes:
a second inlet opening that faces the first outlet opening in the flow direction of the air while being spaced apart from the first outlet opening; and
a second outlet opening that allows the air that has flowed through the inner region to flow out to the outer region, and
the second partition section is formed so that a flow path cross-sectional area of the inner region increases from the second inlet opening toward the second outlet opening.

2. The switchboard according to Claim 1,
wherein an opening area of the second inlet opening is equal to or larger than an opening area of the first outlet opening.

3. The switchboard according to Claim 1 or 2,
wherein the second inlet opening and the second outlet opening have a circular shape.
